(19) Europäisches Patentamt European Patent Office Office européen des brevets

(11) **EP 4 745 591 A1**

(12) **EUROPEAN PATENT APPLICATION**
published in accordance with Art. 153(4) EPC

(43) Date of publication:
20.05.2026 Bulletin 2026/21

(51) International Patent Classification (IPC):
*G01R 31/367* (2019.01)    *G01R 31/392* (2019.01)
*G06F 30/27* (2020.01)

(21) Application number: 23805845.7

(22) Date of filing: 06.09.2023

(52) Cooperative Patent Classification (CPC):
H01M 10/4285; G01R 31/3648; G01R 31/367;
G01R 31/389; G01R 31/392

(86) International application number:
PCT/CN2023/117256

(87) International publication number:
WO 2025/015677 (23.01.2025 Gazette 2025/04)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 14.07.2023 CN 202310864082

(71) Applicant: National Engineering Research Center
of Advanced
Energy Storage Materials (Shenzhen) Co., Ltd
Shenzhen, Guangdong 518000 (CN)

(72) Inventors:
• ZHONG, Faping
  Shenzhen, Guangdong 518000 (CN)
• ZHAO, Peihong
  Shenzhen, Guangdong 518000 (CN)
• LI, Wei
  Shenzhen, Guangdong 518000 (CN)
• TANG, Mingxing
  Shenzhen, Guangdong 518000 (CN)
• ZHOU, Shuliang
  Shenzhen, Guangdong 518000 (CN)

(74) Representative: Zaboliene, Reda
Metida
Business center Vertas
Gyneju str. 16
01109 Vilnius (LT)

(54) **HYBRID ENERGY STORAGE BATTERY STATE MONITORING METHOD AND SYSTEM BASED ON BIG DATA PROCESSING**

(57)    The present invention is a hybrid energy storage battery status monitoring method and system based on big data processing. The method aims at the non-linear and difficult online evaluation problems of the hybrid energy storage battery status. It is set up to collect charging sample information and discharge sample information in sequence. Steps include data sorting and fusion steps, hybrid energy storage battery SOH estimation steps, and hybrid energy storage battery health level evaluation steps to implement business hybrid energy storage battery status monitoring. Among them, the sample data information elements include voltage and current in the charge and discharge state. , power, temperature, internal resistance, through data collection and fusion processing, and data prediction through preset models, it can fully cover the hybrid energy storage battery status, conduct a comprehensive assessment, and improve the accuracy of the assessment.

Acquiring health status parameters of a plurality of hybrid energy storage batteries at different charging states, and forming a charging information element matrix X1, wherein the information elements in the row vectors of the information element matrix include: charging voltage $U_{i1}$, charging current $A_{i1}$, charging power $W_{i1}$, charging temperature $T_{i1}$, and charging internal resistance $R_{i1}$ — S110

Acquiring health status parameters of a plurality of hybrid energy storage batteries at different discharging states, and forming a discharging information element matrix X2, wherein the information elements in the row vectors of the information element matrix include: discharging voltage $U_{i2}$, discharging current $A_{i2}$, discharging power $W_{i2}$, discharging temperature $T_{i2}$, and discharging internal resistance $R_{i2}$ — S111

Preprocessing the health status data under both the charging state and the discharging state to obtain the health status matrix X at the corresponding time — S112

Inputting the data from the health status matrix X into a pre-trained health status model to predict the SOH of the hybrid energy storage batteries — S113

Retrieving, based on the SOH of the hybrid energy storage batteries, the corresponding health grade from a predefined database — S114

FIG. 2

## Description

## Technical field

The invention belongs to the technical field of battery status prediction and health management, and in particular relates to a hybrid energy storage battery status monitoring method and system based on big data processing.

## Background

Due to the continuous consumption of traditional fossil fuels and increasingly serious environmental pollution problems, people are increasingly aware of the importance of clean renewable energy. Batteries have the advantages of long cycle life, high energy density, low self-discharge rate, and low environmental pollution, and are widely used in the electric vehicle industry. With the promotion of electric vehicles in China and the application of Internet of Vehicles technology, more and more electric vehicles have entered the consumer market and collected driving data in real time according to the national standard (GBT32960). As the power source of electric vehicles, power batteries continue to decay as the number of charges and discharges and mileage increase. This reaction is a typical dynamic nonlinear electrochemical time-varying system, and the internal parameters are difficult to measure during online applications. , there are still huge challenges in its degradation state identification and state estimation.

The State of Health (SOH) of a battery refers to the ratio between the actual value and the nominal value of some directly measurable or indirectly calculated performance parameters after the battery has been used for a period of time under certain conditions. It is used to judge Battery health status, usually expressed as a percentage. And SOH is not only related to the electrochemical system and battery manufacturing process of the battery itself, but also to the vehicle driving conditions and the working environment inside the battery pack. For example, the aging degree of lead-acid batteries is affected by many factors, and the battery aging experiment is affected by full charge. The limitations of discharge time and sample number make the selection of representative feature sets based on small samples particularly important in battery SOH prediction. This article adopts a hybrid energy storage battery status monitoring method and system based on big data processing. In the long-term situation that relies on electric vehicle data collection, it uses the battery's rated information and status monitoring data (voltage, current, temperature, internal resistance etc.) to mine the hidden battery health status information and its evolution rules to achieve battery SOH prediction.

## SUMMARY

In order to overcome the shortcomings of the above-mentioned prior art, the present invention discloses a hybrid energy storage battery status monitoring method and system based on big data processing. By extracting the characteristic elements of five batteries in the charging and discharging state, and through sorting and fusion processing , SOH prediction is performed through the preset model, and the accuracy of effective prediction is achieved.

The technical solution adopted in this disclosure is:

The first aspect of the embodiment of the present invention proposes a hybrid energy storage battery status monitoring method based on big data processing, which is applied to a hybrid energy storage battery status monitoring system based on big data processing. The method includes:

Charging sample information collection steps:Obtain the health state parameters of multiple hybrid energy storage batteries in different charging states at different times to form a charging information element matrix X1. The information elements of the row vector of the charging information element matrix X1 include: charging voltage $U_{i1}$, recharging current $A_{i1}$, Charging power $W_{i1}$, Charging temperature $T_{i1}$, Charging internal resistance $R_{i1}$, Expressed as $x_{i1} = \{U_{i1}, A_{i1}, W_{i1}, T_{i1}, R_{i1}\}$, $x_{i1}$, Represents health status data at different moments during charging;

Discharge sample information collection step: Obtain the health state parameters of multiple hybrid energy storage batteries in the discharge state at different times to form a discharge information element matrix X2. The information elements of the row vector of the discharge information element matrix X2 include: discharge voltage $U_{i2}$, Discharge current $A_{i2}$, Discharge power $W_{i2}$, Discharge temperature $T_{i2}$, Discharge internal resistance $R_{i2}$, Expressed as $x_{i2} = \{U_{i2}, A_{i2}, W_{i2}, T_{i2}, R_{i2}\}$, $x_{i2}$ Represents the health status data at different moments during discharge;

Data sorting and fusion steps: Preprocess the health status data in the charging state and the health status data in the discharge state, including: S1. Select the status data in the corresponding proportion space according to the preset threshold ratio, and delete obviously unqualified data; S2. Complete the null value data through the average method; S3. Fusion of the charging sample data and discharge sample data at the corresponding time, expressed as

$$x_i = \left\{ \frac{U_{i1} + U_{i2}}{2}, \frac{A_{i1} + A_{i2}}{2}, \frac{W_{i1} + W_{i2}}{2}, \frac{T_{i1} + T_{i2}}{2}, \frac{R_{i1} + R_{i2}}{2} \right\}$$ , get the health status matrix X at the corresponding moment;

The steps for estimating the SOH of the hybrid energy storage battery: input the data in the health state matrix X into the pre-trained health state model to predict the SOH of the hybrid energy storage battery;

The steps to evaluate the health level of the hybrid energy storage battery:

According to the SOH of the hybrid energy storage battery, search the corresponding health level from the preset database.

Optionally, in the first implementation of the first aspect of the embodiment of the present invention, the data in the health state matrix X is input into a pre-trained health state model to predict the SOH of the hybrid energy storage battery. ,include:

The hybrid verification method is used to predict the SOH of the current hybrid energy storage battery. The formula is:

$$ SOH = \alpha \bullet \frac{C_{now}}{C_{no\min al}} + \beta \bullet \frac{R_{\max} - R_{now}}{R_{\max} - R} + \chi \bullet \frac{Q_{now}}{Q_{no\min al}} \ , $$

in the formula, $C_{now}$ is the current capacity of the battery, $C_{nominal}$ is the rated capacity of the battery, $R_{\max}$, $R_{now}$, $R$ are the maximum internal resistance, current internal resistance, and initial internal resistance of the battery, respectively. $Q_{now}$, $Q_{nominal}$ are the maximum power of the battery when fully charged and the current rated power of the battery, respectively. $\alpha$, $\beta$, $\chi$ Represent the adjustment factors in the corresponding states respectively.

Optionally, in a first implementation manner of the first aspect of the embodiment of the present invention, the health state model is obtained through training, specifically including:

Collect historical sample data uploaded by each edge node to the cloud server through wireless means;

After performing data sorting and fusion processing on the historical sample data, calculate the aggregate value of the sample data of each dimension in the corresponding time window, and calculate the average value of the aggregate value through the support vector;

Establish the corresponding relationship between the sample data of each dimension and store it in the MySQL database form;

Input the processed historical behavior data into the preset initial health state model;

The relevant adjustment factors are calculated through the initial health state model, and on the basis of meeting the performance index threshold, the support vector machine method is used to train the health state model; the prediction results are continuously updated into the known performance index data sequence, and correlation is performed Analysis, depending on the degree of correlation, retraining is performed by expanding the training set, and the health status model is dynamically updated.

Optionally, in a first implementation manner of the first aspect of the embodiment of the present invention, the aggregate value is averaged through a support vector, and the formula is:

average value $b = \frac{1}{|S|} \sum_{s \in S} \left( \frac{1}{y_s} - \sum_{i \in S} a_i y_i x_i^T x_s \right)$ , In the formula, $x_i, y_i$ is the training sample, $(x_s, y_s)$ is any support

vector, $S = \{i | a_i > 0, i = 1, 2, ..., m\}$ is the subscript set of all support vectors, $a_i$ is the Lagrange multiplier.

Optionally, in the first implementation manner of the first aspect of the embodiment of the present invention, the support vector machine method trains the health state model model kernel function as:

$$ f(x) = \sum_{i=1}^{m} (\hat{a}_i - a_i) K(x, x_i) + \frac{1}{2} \| w \|^2 + \sum_{i=1}^{m} a_i (1 - y_i (w^T x_i + b)) \ , $$

in the formula

$K(x,x_i) = \Phi(x_i)^T \phi(x_j)$ is the kernel function,

$\Phi(x_i), \Phi(x_j)$ Respectively represent the sample $x_i, x_j$ Feature vector mapped to high-dimensional feature space, $a_i$ is the Lagrange multiplier, $a_i$ is variable data for $a_i$, $x_i, y_i$ Training samples for support vectors, w is the model parameter, b is the average.

Optionally, in a first implementation manner of the first aspect of the embodiment of the present invention, searching the corresponding health level from a preset database according to the SOH of the hybrid energy storage battery includes:

The mapping relationship between the SOH data range and the health level is established in advance, the corresponding numerical range is searched according to the SOH value obtained by the budget, and the health level assessment is obtained according to the data range through the mapping relationship.

A second aspect of the embodiment of the present invention provides a hybrid energy storage battery status monitoring system based on big data processing. The system is applied to the hybrid energy storage battery status monitoring method based on big data processing and includes a data collection platform. , wherein the data collection platform mainly includes: hybrid energy storage battery pack, wireless gateway, cloud server, and edge node; including:

Charging sample information collection module: obtains the health state parameters of multiple hybrid energy storage batteries in charging states at different times to form a charging information element matrix X1. The information elements of the row vector of the information element matrix include: charging voltage $U_{i1}$, recharging current $A_{i1}$, Charging power $W_{i1}$, Charging temperature $T_{i1}$, Charging internal resistance $R_{i1}$, Expressed as $x_{i1} = \{U_{i1}, A_{i1}, W_{i1}, T_{i1}, R_{i1}\}$, $x_{i1}$ Represents health status data at different moments during charging;

Discharge sample information collection step: Obtain the health state parameters of multiple hybrid energy storage batteries in the discharge state at different times to form a discharge information element matrix X2. The information elements of the row vector of the discharge information element matrix X2 include: discharge voltage $U_{i2}$, Discharge current $A_{i2}$, Discharge power $W_{i2}$, Discharge temperature $T_{i2}$, Discharge internal resistance $R_{i2}$, Expressed as $x_{i2} = U_{i2}, A_{i2}, W_{i2}, T_{i2}, R_{i2}\}$, $x_{i2}$ Represents the health status data at different moments during discharge;

Data sorting and fusion module: Preprocess the health status data in the charging state and the health status data in the discharge state, including: S1. Select the status data in the corresponding proportion space according to the preset threshold ratio, and delete the obviously inappropriate data. Qualified data; S2, fill in the null data through the average method; S3, fuse the charging sample data and discharge sample data at the corresponding time, expressed as

$$x_i = \left\{ \frac{U_{i1} + U_{i2}}{2}, \frac{A_{i1} + A_{i2}}{2}, \frac{W_{i1} + W_{i2}}{2}, \frac{T_{i1} + T_{i2}}{2}, \frac{R_{i1} + R_{i2}}{2} \right\},$$

Get the health status matrix X at the corresponding moment;

Estimation module of hybrid energy storage battery SOH: input the data in the health state matrix X into the pre-trained health state module to predict the SOH of the hybrid energy storage battery;

The health level evaluation module of the hybrid energy storage battery: According to the SOH of the hybrid energy storage battery, the corresponding health level is searched from the preset database.

A third aspect of the embodiment of the present invention provides an electronic device, including a memory, a processor, and a computer program stored on the memory and executable on the processor. When the processor executes the computer program Implement the method for hybrid energy storage battery status monitoring based on big data processing.

A fourth aspect of the embodiment of the present invention provides a computer-readable storage medium, including instructions. When the instructions are run on a computer, the computer performs any of the above-mentioned hybrid energy storage battery status based on big data processing. Monitoring methods.

The beneficial results of the above technical solution of the present invention are as follows:

In the technical solution provided by the embodiment of the present invention, in order to solve the problem of nonlinearity and difficulty in online evaluation of the state of hybrid energy storage batteries, it is set up to sequentially go through the charging sample information collection step and the discharge sample information collection step, and then organize and merge the data. The hybrid energy storage battery The SOH estimation step and the health level evaluation step of the hybrid energy storage battery realize business hybrid energy storage battery status monitoring. Among them, the sample data information elements include voltage, current, power, temperature, and internal resistance in the charge and discharge state. Through the analysis of the data Collation and fusion processing, and data prediction through preset models, can fully cover the status of hybrid energy storage batteries, conduct comprehensive assessments, and improve the accuracy of assessments.

**BRIEF DESCRIPTION OF THE DRAWINGS**

The description drawings that form a part of the present disclosure are used to provide a further understanding of the present disclosure. The illustrative embodiments of the present disclosure and their descriptions are used to explain the present application and do not constitute an improper limitation of the present disclosure.

Figure 1 is the overall structure diagram of the hardware

Figure 2 Schematic diagram of the task scheduling process

Figure 3 Schematic diagram of implementing task scheduling module

## DETAILED DESCRIPTION

The present disclosure will be further described below in conjunction with the accompanying drawings and examples.

It should be noted that the following detailed description is illustrative and is intended to provide further explanation of the present disclosure. Unless otherwise defined, all technical and scientific terms used in this disclosure have the same meanings commonly understood by one of ordinary skill in the art to which this disclosure belongs.

It should be noted that the terms used herein are only for describing specific embodiments and are not intended to limit the exemplary embodiments according to the present application. As used herein, the singular forms are also intended to include the plural forms unless the context clearly indicates otherwise. Furthermore, it will be understood that when the terms "comprises" and/or "includes" are used in this specification, they indicate There are features, steps, operations, means, components and/or combinations thereof.

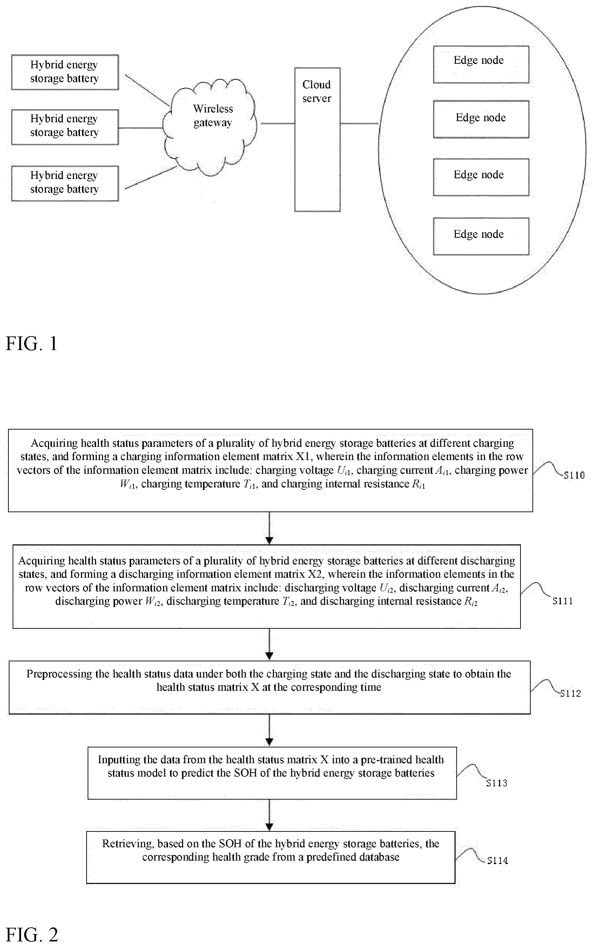

Embodiments of the present invention provide a hybrid energy storage battery status monitoring method and system based on big data processing, which is applied in the communication network architecture as shown in Figure 1; the network structure includes: a data collection platform, wherein the data The collection platform mainly includes: hybrid energy storage battery pack, wireless gateway, cloud server, and edge node. The edge nodes communicate with the cloud server platform through wireless networks. Cloud servers are composed of multiple edge node clusters.

Optionally, the terminal node collects battery status parameters at different times through sensors and uploads them to the cloud server platform through the wireless gateway. The wireless gateway can include (Wireless Fidelity, WIFI for short) communication module, Bluetooth communication (Harold Bluetooth, BLE for short) module, Zigbee communication module, etc., which can be converted into wireless signals to send data through the corresponding serial port.

Please refer to Figure 2, which is a flow chart of a hybrid energy storage battery status monitoring method based on big data processing provided by an embodiment of the present invention, which specifically includes:

Charging sample information collection step: Obtain the health state parameters of multiple hybrid energy storage batteries in different charging states at different times to form a charging information element matrix X1. The information elements of the row vector of the information element matrix include:charging voltage $U_{i1}$, recharging current $A_{i1}$, Charging power $W_{i1}$, Charging temperature $T_{i1}$, Charging internal resistance $R_{i1}$, Expressed as $x_{i1} = \{U_{i1}, A_{i1}, W_{i1}, T_{i1}, R_{i1}\}$, $x_{i1}$ Represents health status data at different moments during charging;

Discharge sample information collection step: Obtain the health state parameters of multiple hybrid energy storage batteries in the discharge state at different times to form a discharge information element matrix X2. The information elements of the row vector of the discharge information element matrix X2 include: discharge voltage $U_{i2}$, Discharge current $A_{i2}$, Discharge power $W_{i2}$, Discharge temperature $T_{i2}$, Discharge internal resistance $R_{i2}$, Expressed as $x_{i2} = U_{i2}, A_{i2}, W_{i2}, T_{i2}, R_{i2}\}$, $x_{i2}$ Represents the health status data at different moments during discharge;

Data sorting and fusion step: Preprocess the health status data in the charging state and the health status data in the discharge state, including:

S1. Select the status data in the corresponding proportion space according to the preset threshold ratio, and delete the obviously inappropriate data. Qualified data; S2, fill in the null data through the average method; S3, fuse the charging sample data and discharge sample data at the corresponding time, expressed as

$$x_i = \left\{ \frac{U_{i1} + U_{i2}}{2}, \frac{A_{i1} + A_{i2}}{2}, \frac{W_{i1} + W_{i2}}{2}, \frac{T_{i1} + T_{i2}}{2}, \frac{R_{i1} + R_{i2}}{2} \right\},$$

get the health status matrix X at the corresponding moment;

The steps for estimating the SOH of the hybrid energy storage battery: input the data in the health state matrix X into the pre-trained health state model to predict the SOH of the hybrid energy storage battery;

The steps to evaluate the health level of the hybrid energy storage battery: According to the SOH of the hybrid energy storage battery, search the corresponding health level from the preset database.

S110. Charging sample information collection step: Obtain the health state parameters of multiple hybrid energy storage batteries in charging states at different times to form a charging information element matrix X1. The information elements of the row vector of the information element matrix include:charging voltage $U_{i1}$, recharging current $A_{i1}$, Charging

power $W_{i1}$, Charging temperature $T_{i1}$, Charging internal resistance $R_{i1}$, Expressed as $x_{i1} = U_{i1}, A_{i1}, W_{i1}, T_{i1}, R_{i1}$ }, $x_{i1}$ Represents health status data at different moments during charging.

Optionally, although the charging state has stable voltage and current, the measured data does not have a stable linear relationship due to differences in ambient temperature, battery temperature, and varying degrees of attenuation of the battery itself. Therefore, the charging voltage in the charging state needs to be $U_{i1}$, recharging current $A_{i1}$, charging power $W_{i1}$, charging temperature $T_{i1}$, charging internal resistance $R_{i1}$ Collection helps optimize predictive models.

S112. Discharge sample information collection step: Obtain the health state parameters of multiple hybrid energy storage batteries in the discharge state at different times to form a discharge information element matrix X2. The information elements of the row vector of the information element matrix include: discharge voltage $U_{i2}$, Discharge current $A_{i2}$, Discharge power $W_{i2}$, Discharge temperature $T_{i2}$, Discharge internal resistance $R_{i2}$, Expressed as $x_{i2} = \{U_{i2}, A_{i2}, W_{i2}, T_{i2}, R_{i2}\}$, $x_{i2}$ Represents the health status data at different moments during discharge.

Optionally, in order to study the discharge status of the battery under different currents, constant current discharge is performed using 5A, 10A, and 15A currents. The voltage, current, temperature and other information during the discharge process are sampled at a frequency of 30S/time.

S113. Data sorting and fusion step: Preprocess the health status data in the charging state and the health status data in the discharge state, including: S3.1. Select the status data in the corresponding proportion space according to the preset threshold ratio. , delete obviously unqualified data; S3.2, fill in the null data through the average method; S3, fuse the charging sample data and discharge sample data at the corresponding time, expressed as

$$x_i = \left\{ \frac{U_{i1} + U_{i2}}{2}, \frac{A_{i1} + A_{i2}}{2}, \frac{W_{i1} + W_{i2}}{2}, \frac{T_{i1} + T_{i2}}{2}, \frac{R_{i1} + R_{i2}}{2} \right\},$$

obtain the health state matrix X at the corresponding time.

S114. The step of estimating the SOH of the hybrid energy storage battery: input the data in the health state matrix X into the pre-trained health state model to predict the SOH of the hybrid energy storage battery.

Optionally, input the data in the health state matrix X into a pre-trained health state model to predict the SOH of the hybrid energy storage battery, including: using a hybrid verification method to predict the SOH of the current hybrid energy storage battery. , the formula is:

$$SOH = \alpha \bullet \frac{C_{now}}{C_{no\,min\,al}} + \beta \bullet \frac{R_{\max} - R_{now}}{R_{\max} - R} + \chi \bullet \frac{Q_{now}}{Q_{no\,min\,al}},$$

in the formula, $C_{now}$ is the current capacity of the battery, $C_{nominal}$ is the rated capacity of the *battery*, $R_{\max}$, $R_{now}$, $R$ are the maximum internal resistance, current internal resistance, and initial internal resistance of the battery, respectively. $Q_{now}$, $Q_{nominal}$ are the maximum power of the battery when fully charged and the current rated power of the battery, respectively. $\alpha$, $\beta$, $\chi$ Represent the adjustment factors in the corresponding states respectively.

Preferably, the health status model is obtained through training, which specifically includes: S4.1 wirelessly collecting historical sample data uploaded by each edge node to the cloud server; S4.2 performing data sorting and fusion processing on the historical sample data. , calculate the aggregate value of the sample data of each dimension in the corresponding time window, and the aggregate value is averaged through the support vector; S4.3 establishes the corresponding relationship between the sample data of each dimension and stores it in the MySQL database form; S4. 4. Input the processed historical behavior data into the preset initial health state model; S4.5 calculate the relevant adjustment factors through the initial health state model, and use the support vector machine method to train the health state on the basis of meeting the performance index threshold. Model; S4.6 continuously updates the prediction results to the known performance indicator data sequence, and performs correlation analysis. Depending on the degree of correlation, retraining is performed by expanding the training set to dynamically update the health status model.

Preferably, the initial health state model is pre-established based on a bidirectional long short-term memory (LSTM) recurrent neural network.

Optionally, the aggregated values are averaged through support vectors, the formula is::average value

$$b = \frac{1}{|S|} \sum_{s \in S} \left( \frac{1}{y_s} - \sum_{i \in S} a_i y_i x_i^T x_s \right),$$

In the formula, $x_i$, $y_i$ is the training sample, $(x_s, y_s)$ is any support vector, $S = \{i \,|\, a_i > 0, i = 1, 2, ..., m\}$ is the subscript set of all support vectors, $a_i$ is the Lagrange multiplier.

Optionally, in the first implementation manner of the first aspect of the embodiment of the present invention, the support vector machine method trains the health state model model kernel function as:

$$f(x) = \sum_{i=1}^{m} (\hat{a}_i - a_i) K(x, x_i) + \frac{1}{2} \| w \|^2 + \sum_{i=1}^{m} a_i (1 - y_i (w^T x_i + b)) \ ,$$

in the formula

$K(x, x_i) = \Phi(x_i)^T \phi(x_j)$ is the kernel function,
$\Phi(x_i)$, $\Phi(x_j)$ Respectively represent the sample $x_i, x_j$ Feature vector mapped to high-dimensional feature space, $a_i$ is the Lagrange multiplier, $\hat{a}_i$ is variable data for $a_i$, $x_i, y_i$ Training samples for support vectors, $w$ is the model parameter, b is the average.

S115. Steps for evaluating the health level of the hybrid energy storage battery: According to the SOH of the hybrid energy storage battery, search the corresponding health level from the preset database.

Optionally, searching for the corresponding health level from a preset database according to the SOH of the hybrid energy storage battery includes: establishing a mapping relationship between the SOH data range and the health level in advance, and searching for the corresponding SOH value based on the budget. The numerical range of , the health level assessment is obtained through the mapping relationship according to the data range.

Embodiments of the present invention also provide a hybrid energy storage battery status monitoring system based on big data processing, which is applied in a cloud-coordinated communication network based on platform business types as shown in Figure 1.

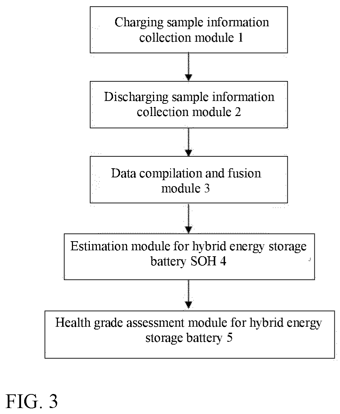

As shown in Figure 3, the system includes: charging sample information collection module 1, discharge sample information collection module 2, data sorting and fusion module 3, hybrid energy storage battery SOH estimation module 4, hybrid energy storage battery health level evaluation step 5 .

The charging sample information collection module 1 is used to obtain the health state parameters of multiple hybrid energy storage batteries in different charging states at different times to form a charging information element matrix X1. The information elements of the row vector of the information element matrix include:charging voltage $U_{i1}$, recharging current $A_{i1}$, Charging power $W_{i1}$, Charging temperature $T_{i1}$, Charging internal resistance $R_{i1}$.

The discharge sample information collection module 2 is used to obtain the health state parameters of multiple hybrid energy storage batteries in the discharge state at different times to form a discharge information element matrix X2. The information elements of the row vector of the information element matrix include:discharge voltage $U_{i2}$, Discharge current $A_{i2}$, Discharge power $W_{i2}$, Discharge temperature $T_{i2}$ , Discharge internal resistance $R_{i2}$.

The data sorting and fusion module 3 is used to preprocess the health status data in the charging state and the health status data in the discharge state, including: S1. Select the status data in the corresponding proportion space according to the preset threshold ratio, and delete Obviously unqualified data; S2, fill in the null data through the average method; S3, fuse the charging sample data and discharge sample data at the corresponding time;

The estimation module 4 of the hybrid energy storage battery SOH is used to input the data in the health state matrix X into the pre-trained health state module to predict the SOH of the hybrid energy storage battery;

The health level evaluation step 5 of the hybrid energy storage battery is used to find the corresponding health level from the preset database based on the SOH of the hybrid energy storage battery.

An embodiment of the present invention also provides an electronic device, including a memory, a processor, and a computer program stored in the memory and executable on the processor. When the processor executes the computer program, the A method for condition monitoring of hybrid energy storage batteries based on big data processing.

Embodiments of the present invention also provide a computer-readable storage medium, which includes instructions. When the instructions are run on a computer, they cause the computer to perform the method for monitoring the state of a hybrid energy storage battery based on big data processing.

Although the specific embodiments of the present disclosure have been described above in conjunction with the accompanying drawings, they do not limit the scope of the present disclosure. Those skilled in the art should understand that based on the technical solutions of the present disclosure, those skilled in the art do not need to make creative efforts. Various modifications or deformations can be made and still fall within the scope of the present disclosure.

**Claims**

1. A method for monitoring hybrid energy storage state of battery based on big data processing, **characterized in that** a hybrid energy storage battery status monitoring system applied to big data processing, the method includes:

   Charging sample information collection step: Obtain the health state parameters of multiple hybrid energy storage batteries in different charging states at different times to form a charging information element matrix X1. The information elements of the row vector of the charging information element matrix X1 include: charging voltage $U_{i1}$, recharging current $A_{i1}$, Charging power $W_{i1}$, Charging temperature $T_{i1}$, Charging internal resistance $R_{i1}$, Expressed as $x_{i1} = \{U_{i1}, A_{i1}, W_{i1}, T_{i1}, R_{i1}\}$, $x_{i1}$ Represents health status data at different moments during charging;

   Discharge sample information collection step: Obtain the health state parameters of multiple hybrid energy storage batteries in the discharge state at different times to form a discharge information element matrix X2. The information elements of the row vector of the discharge information element matrix X2 include: discharge voltage $U_{i2}$, Discharge current $A_{i2}$, Discharge power $W_{i2}$, Discharge temperature $T_{i2}$, Discharge internal resistance $R_{i2}$, Expressed as $x_{i2} = \{U_{i2}, A_{i2}, W_{i2}, T_{i2}, R_{i2}\}$, $x_{i2}$ Represents the health status data at different moments during discharge;

   Data sorting and fusion steps: Preprocess the health status data in the charging state and the health status data in the discharge state, including:

   S1. Select the status data in the corresponding proportion space according to the preset threshold ratio, and delete obviously unqualified data; S2. Complete the null value data through the average method; S3. Fusion of the charging sample data and discharge sample data at the corresponding time, expressed as

   $$x_i = \left\{ \frac{U_{i1} + U_{i2}}{2}, \frac{A_{i1} + A_{i2}}{2}, \frac{W_{i1} + W_{i2}}{2}, \frac{T_{i1} + T_{i2}}{2}, \frac{R_{i1} + R_{i2}}{2} \right\}$$ , Get the health status matrix X at the corresponding moment;

   Estimation steps of hybrid energy storage battery SOH: input the data in the health state matrix X into the pre-trained health state model to predict the SOH of the hybrid energy storage battery;

   The steps to evaluate the health level of the hybrid energy storage battery: According to the SOH of the hybrid energy storage battery, search the corresponding health level from the preset database.

2. A method for monitoring hybrid energy storage state of battery based on big data processing according to claim 1, **characterized in that** the data in the health status matrix It can predict the SOH of the battery, including: The hybrid verification method is used to predict the SOH of the current hybrid energy storage battery. The formula is:

   $$SOH = \alpha \bullet \frac{C_{now}}{C_{no\min al}} + \beta \bullet \frac{R_{\max} - R_{now}}{R_{\max} - R} + \chi \bullet \frac{Q_{now}}{Q_{no\min al}} ,$$

   in the formula, $C_{now}$ is the current capacity of the battery, $C_{nominal}$ is the rated capacity of the battery, $R_{\max}, R_{now}, R$ are the maximum internal resistance, current internal resistance, and initial internal resistance of the battery, respectively. $Q_{now}, Q_{nominal}$ are the maximum power of the battery when fully charged and the current rated power of the battery, respectively. $\alpha, \beta, \chi$ Represent the adjustment factors in the corresponding states respectively.

3. A method for monitoring hybrid energy storage state of battery based on big data processing according to claim 1, **characterized in that** the health status model is obtained through training, specifically including:

   Collect historical sample data uploaded by each edge node to the cloud server through wireless means;
   After performing data sorting and fusion processing on the historical sample data, calculate the aggregate value of the sample data of each dimension in the corresponding time window, and the aggregate value is obtained by solving the average value of the support vector;
   Establish the corresponding relationship between the sample data of each dimension and store it in the MySQL database form;
   Input the processed historical behavior data into the preset initial health state model;
   The relevant adjustment factors are calculated through the initial health state model, and on the basis of meeting the performance index threshold, the support vector machine method is used to train the health state model;
   the prediction results are continuously updated into the known performance index data sequence, and correlation is performed Analysis, depending on the degree of correlation, retraining is performed by expanding the training set, and the health status model is dynamically updated.

**4.** A method for monitoring hybrid energy storage state of battery based on big data processing according to claim 3, **characterized in that** the aggregate value is obtained by solving the average value of the support vector, and the formula is:average value $b = \dfrac{1}{|S|}\sum_{s \in S}\left(\dfrac{1}{y_s} - \sum_{i \in S} a_i y_i x_i^T x_s\right)$ , In the formula, $x_i, y_i$ is the training sample, $(x_s, y_s)$ is any support vector, $S = \{i\,|\,a_i > 0, i = 1,2,...,m\,\}$is the subscript set of all support vectors, $a_i$ is the Lagrange multiplier.

**5.** A method for monitoring hybrid energy storage state of battery based on big data processing according to claim 4, **characterized in that**:

The kernel function of the support vector machine method for training the health state model is:

$$f(x) = \sum_{i=1}^{m} (\hat{a}_i - a_i)K(x, x_i) + \frac{1}{2}\|w\|^2 + \sum_{i=1}^{m} a_i(1 - y_i(w^T x_i + b)) \, ,$$

in the formula

$K(x, x_i) = \Phi(x_i)^T \phi(x_j)$ is the kernel function,

$\Phi(x_i)$, $\Phi(x_j)$ Respectively represent the sample $x_i, x_j$ Feature vector mapped to high-dimensional feature space, $a_i$ is the Lagrange multiplier, $\hat{a}_i$ is variable data for $a_i, x_i, y_i$ Training samples for support vectors, $w$ is the model parameter, b is the average.

**6.** A method for monitoring hybrid energy storage state of battery based on big data processing according to claim 1, **characterized in that**:

According to the SOH of the hybrid energy storage battery, the corresponding health level is searched from the preset database, including:

The mapping relationship between the SOH value range and the health level is established in advance, the corresponding value range is searched based on the pre-obtained SOH value, and the health level assessment is obtained through the mapping relationship based on the value range.

**7.** A system for monitoring hybrid energy storage state of battery based on big data processing. The system is applied to the hybrid energy storage battery status monitoring method based on big data processing of claim 1, including a data collection platform, wherein the data collection The platform includes: hybrid energy storage battery pack, wireless gateway, cloud server, and edge nodes; including:

Charging sample information collection module: obtains the health status parameters of multiple hybrid energy storage batteries in different charging states at different times to form a charging information element matrix X1. The information elements of the row vector of the charging information element matrix X1 include: charging voltage $U_{i1}$, recharging current $A_{i1}$, Charging power $W_{i1}$, Charging temperature $T_{i1}$, Charging internal resistance $R_{i1}$ , Expressed as $x_{i1} = \{U_{i1}, A_{i1}, W_{i1}, T_{i1}, R_{i1}\}$ , $x_{i1}$ Represents health status data at different moments during charging;

Discharge sample information collection module: obtains the health status parameters of multiple hybrid energy storage batteries in the discharge state at different times to form a discharge information element matrix X2. The information elements of the row vector of the discharge information element matrix include: discharge voltage $U_{i2}$, Discharge current $A_{i2}$, Discharge power $W_{i2}$, Discharge temperature $T_{i2}$, Discharge internal resistance $R_{i2}$, Expressed as $x_{i2} = \{U_{i2}, A_{i2}, W_{i2}, T_{i2}, R_{i2}\}$, $x_{i2}$ Represents the health status data at different moments during discharge;

Data sorting and fusion module: Preprocess the health status data in the charging state and the health status data in the discharge state, including:

S1. Select the status data in the corresponding proportion space according to the preset threshold ratio, and delete obviously unqualified data; S2. Complete the null value data through the average method; S3. Fusion of the charging sample data and discharge sample data at the corresponding time, expressed as

$$x_i = \left\{ \frac{U_{i1} + U_{i2}}{2}, \frac{A_{i1} + A_{i2}}{2}, \frac{W_{i1} + W_{i2}}{2}, \frac{T_{i1} + T_{i2}}{2}, \frac{R_{i1} + R_{i2}}{2} \right\}$$

, Get the health status matrix X at the corresponding moment;

Estimation module of hybrid energy storage battery SOH: input the data in the health state matrix X into the pre-trained health state module to predict the SOH of the hybrid energy storage battery;

The health level evaluation module of the hybrid energy storage battery: According to the SOH of the hybrid energy storage battery, the corresponding health level is searched from the preset database.

8. An electronic device, **characterized in that** it includes a memory, a processor and a computer program stored in the memory and run on the processor. When the processor executes the computer program, it implements claim 1 to 6 A hybrid energy storage battery status monitoring method based on big data processing according to any one of claims 1 to 6.

9. A computer-readable storage medium, **characterized in that** it includes instructions that, when the instructions are run on a computer, cause the computer to execute a method based on big data processing as described in any one of claims 1 to 6. Hybrid energy storage battery condition monitoring method.

$$x_i = \left\{ \frac{U_{i1} + U_{i2}}{2}, \frac{A_{i1} + A_{i2}}{2}, \frac{W_{i1} + W_{i2}}{2}, \frac{T_{i1} + T_{i2}}{2}, \frac{R_{i1} + R_{i2}}{2} \right\}$$

Hybrid energy
storage battery

Hybrid energy
storage battery

Hybrid energy
storage battery

Wireless
gateway

Cloud
server

Edge node

Edge node

Edge node

Edge node

FIG. 1

Acquiring health status parameters of a plurality of hybrid energy storage batteries at different charging states, and forming a charging information element matrix X1, wherein the information elements in the row vectors of the information element matrix include: charging voltage $U_{i1}$, charging current $A_{i1}$, charging power $W_{i1}$, charging temperature $T_{i1}$, and charging internal resistance $R_{i1}$ ── S110

Acquiring health status parameters of a plurality of hybrid energy storage batteries at different discharging states, and forming a discharging information element matrix X2, wherein the information elements in the row vectors of the information element matrix include: discharging voltage $U_{i2}$, discharging current $A_{i2}$, discharging power $W_{i2}$, discharging temperature $T_{i2}$, and discharging internal resistance $R_{i2}$ ── S111

Preprocessing the health status data under both the charging state and the discharging state to obtain the health status matrix X at the corresponding time ── S112

Inputting the data from the health status matrix X into a pre-trained health status model to predict the SOH of the hybrid energy storage batteries ── S113

Retrieving, based on the SOH of the hybrid energy storage batteries, the corresponding health grade from a predefined database ── S114

FIG. 2

FIG. 3

## INTERNATIONAL SEARCH REPORT

| International application No. |
|---|
| **PCT/CN2023/117256** |

**A. CLASSIFICATION OF SUBJECT MATTER**

G01R31/367(2019.01)i; G01R31/392(2019.01)i; G06F30/27(2020.01)i

According to International Patent Classification (IPC) or to both national classification and IPC

**B. FIELDS SEARCHED**

Minimum documentation searched (classification system followed by classification symbols)

IPC:G01R31 G06F30

Documentation searched other than minimum documentation to the extent that such documents are included in the fields searched

Electronic data base consulted during the international search (name of data base and, where practicable, search terms used)

CNABS, CNTXT, CNKI, 万方, WANFANG: 电池, 健康状态, SOH, 充电, 放电, 聚合, 融合, 整合, 混合, 联合, 结合, 模型, 预测, 计算, 评估, 容量, 内阻, 电量, 因子, 权重, 系数, 比重, 占比, 等级, 范围, 平均, 均值, 支持向量, SVM, 长短时记忆, LSTM; VEN, USTXT, WOTXT, EPTXT: battery, state of health, SOC, charge, discharge, fusion, confluence, condensation, mixing, merger, model, predict, evaluate, capability, resistance, electric quantity, factor, weight, coefficient, proportion, grade, rank, bound, average, mean, Support Vector Machine, SVM, long short term memory, LSTM

**C. DOCUMENTS CONSIDERED TO BE RELEVANT**

| Category* | Citation of document, with indication, where appropriate, of the relevant passages | Relevant to claim No. |
|---|---|---|
| PX | CN 116609676 A (SHENZHEN NATIONAL ENGINEERING RESEARCH CENTER OF ADVANCED ENERGY STORAGE MATERIALS CO., LTD.) 18 August 2023 (2023-08-18) claims 1-2 and 6-9 | 1-2, 6-9 |
| Y | CN 114994541 A (CHINA JILIANG UNIVERSITY) 02 September 2022 (2022-09-02) description, paragraphs 34-55, and figure 1 | 1-2, 6-9 |
| Y | CN 111103551 A (BEIQI FOTON MOTOR CO., LTD.) 05 May 2020 (2020-05-05) description, paragraphs 81-142, and figures 1-4 | 1-2, 6-9 |
| Y | CN 115859150 A (CHINA ELECTRONIC PRODUCT RELIABILITY AND ENVIRONMENTAL TESTING RESEARCH INSTITUTE ((FIFTH ELECTRONIC RESEARCH INSTITUTE OF MIIT) (CHINA CEPREI LABORATORY))) 28 March 2023 (2023-03-28) description, paragraphs 50-137, and figure 2 | 1-2, 6-9 |

☑ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **04 March 2024** | **15 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/117256**

### C. DOCUMENTS CONSIDERED TO BE RELEVANT

| Category* | Citation of document, with indication, where appropriate, of the relevant passages | Relevant to claim No. |
|---|---|---|
| Y | CN 112034350 A (XIAMEN KECAN INFORMATION TECHNOLOGY CO., LTD. et al.) 04 December 2020 (2020-12-04)<br>description, paragraphs 21-86, and figures 1-2 | 1-2, 6-9 |
| A | CN 111896873 A (CHINA ELECTRIC POWER RESEARCH INSTITUTE CO., LTD. et al.) 06 November 2020 (2020-11-06)<br>entire document | 1-2, 6-9 |
| A | CN 111337832 A (NANJING UNIVERSITY OF AERONAUTICS AND ASTRONAUTICS) 26 June 2020 (2020-06-26)<br>entire document | 1-2, 6-9 |
| A | CN 108549032 A (BEIJING IDRIVE AUTOMOBILE CO., LTD.) 18 September 2018 (2018-09-18)<br>entire document | 1-2, 6-9 |
| A | CN 103020445 A (SOUTHWEST JIAOTONG UNIVERSITY et al.) 03 April 2013 (2013-04-03)<br>entire document | 1-2, 6-9 |
| A | CN 115656855 A (SHANGHAI WUYANG SHIP TECHNOLOGY CO., LTD.) 31 January 2023 (2023-01-31)<br>entire document | 1-2, 6-9 |
| A | CN 115343621 A (SHANDONG UNIVERSITY OF SCIENCE AND TECHNOLOGY) 15 November 2022 (2022-11-15)<br>entire document | 1-2, 6-9 |
| A | KR 102397534 B1 (BA ENERGY CO., LTD.) 16 May 2022 (2022-05-16)<br>entire document | 1-2, 6-9 |

Form PCT/ISA/210 (second sheet) (July 2022)

## INTERNATIONAL SEARCH REPORT
### Information on patent family members

International application No.

**PCT/CN2023/117256**

| Patent document cited in search report | | | Publication date (day/month/year) | Patent family member(s) | | | Publication date (day/month/year) |
|---|---|---|---|---|---|---|---|
| CN | 116609676 | A | 18 August 2023 | CN | 116609676 | B | 15 September 2023 |
| CN | 114994541 | A | 02 September 2022 | | None | | |
| CN | 111103551 | A | 05 May 2020 | CN | 111103551 | B | 17 September 2021 |
| CN | 115859150 | A | 28 March 2023 | | None | | |
| CN | 112034350 | A | 04 December 2020 | CN | 112034350 | B | 14 July 2023 |
| CN | 111896873 | A | 06 November 2020 | CN | 111896873 | B | 14 March 2023 |
| CN | 111337832 | A | 26 June 2020 | CN | 111337832 | B | 10 January 2023 |
| CN | 108549032 | A | 18 September 2018 | | None | | |
| CN | 103020445 | A | 03 April 2013 | CN | 103020445 | B | 06 July 2016 |
| CN | 115656855 | A | 31 January 2023 | | None | | |
| CN | 115343621 | A | 15 November 2022 | CN | 115343621 | B | 26 January 2024 |
| KR | 102397534 | B1 | 16 May 2022 | | None | | |

Form PCT/ISA/210 (patent family annex) (July 2022)